# EUROPEAN PATENT APPLICATION

(11) **EP 4 360 776 A1**
(43) Date of publication of application: **01.05.2024**
(21) Application number: 22864592.5
(22) Date of filing: 30.08.2022
(51) Int. Cl.: B22F 1/00, B22F 1/14, B22F 1/16, B22F 3/105, B22F 3/16, B22F 10/34, B33Y 70/00

(54) **PURE COPPER OR COPPER ALLOY POWDER FOR DEPOSITION MODELING**

(30) Priority: 01.09.2021 JP 2021142629
(71) Applicant: JX Metals Corporation, Tokyo 105-8417 (JP)
(72) Inventor: WATANABE, Hirofumi, Kitaibaraki-shi, Ibaraki 319-1535 (JP); SHIBUYA, Yoshitaka, Kitaibaraki-shi, Ibaraki 319-1535 (JP); KUMAGAI, Masashi, Tokyo 105-8417 (JP)
(74) Representative: Forresters IP LLP
(86) International application number: PCT/JP2022/032685
(87) International publication number: WO 2023/033010

(57) **Abstract**

An object of the present invention is to provide a pure copper or copper alloy powder for use in additive manufacturing using a laser beam system, and which is capable of increasing the laser absorptance and simultaneously decreasing the oxygen concentration in an object. Provided is a pure copper or copper alloy powder with an oxide coating, wherein the oxide coating contains carbon, and a ratio of the oxygen concentration to the carbon concentration ((oxygen concentration)/(carbon concentration)) is 5 or less.

## Description

### [Technical Field]

The present invention relates to a pure copper or copper alloy powder for additive manufacturing.

### [Background Art]

In recent years, attempts are being made for using metal 3D printer technology and producing three-dimensional metal components which have a complex shape and are deemed difficult to form. Metal 3D printing is also referred to as additive manufacturing (AM), and as one such method, there is a method of producing a complex-shape metal object by thinly spreading a metal powder on a substrate to form a metal powder layer, melting the metal powder layer by selectively scanning the metal powder layer with a laser beam or an electron beam based on two-dimensional data and subsequently solidifying the metal powder layer, thinly spreading a new powder thereon and similarly melting the metal powder layer by selectively scanning the metal powder layer with a laser beam or an electron beam and subsequently solidifying the metal powder layer, and repeating these processes.

In preparing an additive manufactured object (hereinafter sometimes simply referred to as an "object"), efforts are being exerted for using pure copper or copper alloy having superior conductivity and thermal conductivity. In the foregoing case, additive manufacturing is performed by irradiating the pure copper or copper alloy powder with a laser beam, but since pure copper or copper alloy has low laser absorptance (laser absorptance of pure copper alone is 10 to 20%), and also has high thermal conductivity and heat leakage is great, powder cannot be sufficiently melted with an ordinary laser output, and there was a problem in that additive manufacturing is difficult. Moreover, while it is also possible to consider performing irradiation for a long period using a high power laser in order to melt the pure copper or copper alloy powder, in the foregoing case, there is a problem in that the load of the laser is great, and the productivity is inferior.

Patent Document 1 and Patent Document 2 disclose technologies of providing an oxide coating by heating an atomized powder of copper in an oxidizing atmosphere in order to increase the laser absorptance. Patent Document 1 and Patent Document 2 are superior technologies capable of increasing the laser absorptance with an oxide coating. Nevertheless, there were cases where slag (copper oxide) is formed during the additive manufacturing process, which remains without melting and ultimately generates voids (pores) in the additive manufactured object, and causes the relative density to deteriorate.

Patent Document 3 and Patent Document 4 describe coating a metal powder with an organic compound in order to increase the laser absorptance. Patent Document 3 and Patent Document 4 are superior technologies capable of increasing the laser absorptance based on the coating of an organic compound. Nevertheless, there is a possibility that the coating may deteriorate due to the thermal conduction during the additive manufacturing process, and it may not be possible to repeatedly use the powder.

Patent Document 5 describes a technology of facilitating the additive manufacturing process by lowering the thermal conductivity than that of pure copper by using a copper alloy powder, in which a prescribed amount of chromium (Cr) has been added to copper (Cu), as the additive manufacturing powder.

### [Prior Art Documents]

### [Patent Documents]

[Patent Document 1] Japanese Unexamined Patent Application Publication No. 2018-178239
[Patent Document 2] Japanese Unexamined Patent Application Publication No. 2020-186429
[Patent Document 3] Japanese Unexamined Patent Application Publication No. 2018-199662
[Patent Document 4] Japanese Unexamined Patent Application Publication No. 2020-190008
[Patent Document 5] Japanese Unexamined Patent Application Publication No. 2019-44260

### [Disclosure of the Invention]

### [Problems to be Solved by the Invention]

An object of the present invention is to provide a pure copper or copper alloy powder for use in additive manufacturing using a laser beam system, and which is capable of increasing the laser absorptance and simultaneously decreasing the oxygen concentration in an object.

### [Means for Solving the Problems]

One mode of the present invention is a pure copper or copper alloy powder with an oxide coating, wherein the oxide coating contains carbon, and a ratio of an oxygen concentration to a carbon concentration ((oxygen concentration)/(carbon concentration)) is 5 or less.

### [Effect of the Invention]

According to the present invention, the laser absorptance of the pure copper or copper alloy powder for use in additive manufacturing and the oxygen concentration in the object can be decreased in the additive manufacturing using a laser beam system. Consequently, the suppression of deterioration in characteristics such as the mechanical strength and conductivity of the object can be expected. Moreover, the pure copper or copper alloy powder can be sufficiently melted even with a low-output laser beam, and reduction of the load on the laser can also be expected.

### [Best Mode for Carrying Out the Invention]

When forming an object of a pure copper or copper alloy based on additive manufacturing using a laser beam system, there was a problem in that the powder could not be fully melted since copper has low laser absorptance and could not be heated sufficiently. Moreover, since copper has high thermal conductivity, there was also a problem in that the range of formation could not be fully melted. In light of the foregoing problems, efforts are being exerted for improving the laser absorptance by subjecting copper to oxidation treatment (Patent Documents 1 and 2).

While the foregoing efforts can considerably improve the laser absorptance, when the oxygen concentration is high, oxygen tends to remain as oxides in the object, and there is a problem in that characteristics such as the mechanical strength and conductivity of the object will deteriorate. As a result of intense study of these problems, the present inventors discovered that oxygen and carbon become bound during the additive manufacturing process by forming an oxide coating on the pure copper or copper alloy powder and adding an appropriate amount of carbon to the oxide coating, and, by removing oxygen as carbon monoxide or carbon dioxide, it is possible to decrease the oxygen concentration in the object while increasing the laser absorptance.

Based on the foregoing discovery, an embodiment of the present invention is a pure copper or copper alloy powder with an oxide coating, wherein the oxide coating contains carbon, and a ratio of an oxygen concentration to a carbon concentration (oxygen concentration/carbon concentration) is 5 or less. Here, the carbon concentration and the oxygen concentration are respectively a mass concentration. As a result of causing the carbon concentration and the oxygen concentration to fall within the range of the foregoing ratio, carbon becomes bound to oxygen during the additive manufacturing process, and oxygen and carbon can be effectively removed as carbon monoxide or carbon dioxide, and the influence on the object as a result of oxides remaining in the object can be reduced. The oxide coating in the present application is not limited to the oxide coating formed intentionally by heating the pure copper or copper alloy powder, and may also be an oxide coating that is naturally formed in the atmosphere.

When the oxygen concentration/carbon concentration exceeds 5, the possibility of oxygen (oxides or the like) remaining in the object will increase, and there is concern of causing an adverse effect such as the deterioration of strength and the deterioration of conductivity of the object. The oxygen concentration/carbon concentration is preferably 1 or less. Meanwhile, when the ratio of the carbon concentration is too high, since carbon will remain as an impurity, the oxygen concentration/carbon concentration is preferably 0.01 or more. By causing the ratio of the oxygen concentration/carbon concentration to fall within the foregoing numerical range, oxygen and carbon can be effectively removed as carbon monoxide or carbon dioxide during the additive manufacturing process.

In this embodiment, the oxygen concentration of the pure copper or copper alloy powder is 5000 wtppm or less, preferably 3000 wtppm or less, and more preferably 1500 wtppm or less. Meanwhile, the oxygen concentration is preferably 50 wtppm or more, and more preferably 100 wtppm or more. When an oxide coating is formed on the surface of the pure copper or copper alloy powder, while the laser absorptance can be increased on the one hand, the oxygen concentration will increase during the additive manufacturing process, and may cause the deterioration in various characteristics. Accordingly, to restrict the oxygen concentration in the pure copper or copper alloy powder to a certain amount is effective for both increasing the laser absorptance and suppressing the deterioration in characteristics of the object.

While the carbon concentration can be adjusted in consideration of the oxygen concentration, the carbon concentration is preferably 100 wtppm or more, more preferably 150 wtppm or more, and most preferably 200 wtppm or more. When the carbon concentration is insufficient relative to the concentration of oxygen existing mainly as oxides, oxygen cannot be sufficiently removed during the additive manufacturing process, and it may not be possible to sufficiently reduce the oxygen concentration of the ultimately obtained object. Meanwhile, when the carbon concentration relative to oxygen is too high, carbon will remain in the object and lead to the deterioration of the relative density. Accordingly, the carbon concentration is preferably 5000 wtppm or less, more preferably 3000 wt or less, and most preferably 1000 wtppm or less.

In this embodiment, the pure copper or copper alloy powder on which an oxide coating has been formed is preferably added with heat-resistant carbon that will not decompose easily even at a high temperature. As heat-resistant carbon, for instance, amorphous carbon or graphite may be used. Laser absorptance can be increased, even when increasing the temperature until the powder is melted, by causing heat-resistant carbon to exist, and it is considered that this can improve the formability. Moreover, the thermal conductivity of the powder can be lowered, and the thermal diffusion can be suppressed. While organic matter without any heat resistance tends to disappear and it is difficult to suppress the heat release during the additive manufacturing process, since carbon has a heat-resistant structure, heat release can also be suppressed during the additive manufacturing process.

Raman spectroscopy may be used as the method of analyzing the binding state (structure) of carbon. With Raman spectroscopy, the binding state of atoms on the surface can be confirmed, and in particular a detailed analysis of the binding of carbon is possible. When measuring the pure copper or copper alloy powder according to this embodiment with Raman spectroscopy, there are cases where a maximum scattering intensity value in a Raman shift of 1000 to 2000 cm⁻¹ exists within a range of a Raman shift of 1300 to 1700 cm⁻¹. It is possible to determine that the carbon has a graphite structure as a result of a maximum scattering intensity appearing within a range of a Raman shift of 1300 to 1700 cm⁻¹.

When the Cu LMM spectrum of the pure copper or copper alloy powder according to this embodiment is analyzed with XPS (X-ray Photoelectron Spectroscopy), a maximum peak intensity preferably exists at a binding energy of 569 to 571 eV. With copper alone, while a maximum peak intensity appears at a binding energy of 568 eV or less, with copper oxide (I) and copper oxide (II), a maximum peak intensity appears at a binding energy of 569 to 571 eV. As a result of copper adopting a form as copper oxide, since the laser absorptance will increase and the formability can be improved, the copper of the powder surface preferably exists in the form of copper oxide (I) or copper oxide (II).

In this embodiment, the film thickness of the oxide coating formed on the surface of the pure copper or copper alloy powder is preferably 5 nm or more and 500 nm or less. When the film thickness of the oxide coating is too thick, it may lead to the deterioration of the relative density of the ultimately obtained additive manufactured object during the additive manufacturing process using a laser beam. Meanwhile, when the film thickness of the oxide coating is too thin, increase of the laser absorptance will be insufficient, and there is a possibility that the pure copper or copper alloy powder cannot be fully melted. A high density additive manufactured object can be obtained by adjusting the film thickness of the oxide coating formed on the surface of the pure copper or copper alloy powder.

In this embodiment, the average particle size D₅₀ (median diameter) of the pure copper or copper alloy powder is preferably 10 µm or more and 150 µm or less. When the average particle size D₅₀ is 10 µm or more, the powder does not float easily during the formation process, and it becomes easier to handle the powder. Meanwhile, by causing the average particle size D₅₀ to be 150 µm or less, it becomes easier to produce a further highly refined object. Note that, in the present specification, the term "average particle size D₅₀" means the average particle size at an integrated value of 50% in a particle size distribution measured based on image analysis.

As the pure copper powder according to this embodiment, pure copper having a purity of 3N (99.9 wt%) or higher is preferably used. Moreover, as the copper alloy powder according to this embodiment, a copper alloy powder containing copper in an amount of 80 wt% or higher, 85 wt% or higher, 90 wt% or higher, 95 wt% or higher, or 99 wt% or higher is preferably used. Moreover, as the alloy element, one or more types among Al, Cr, Fe, Ni, Nb, P, Si, Zn, and Zr are preferably used.

The additive manufactured object prepared using the pure copper or copper alloy powder according to this embodiment can be expected to have superior physical properties such as high conductivity. Generally speaking, when the oxygen concentration of the additive manufactured object exceeds 200 wtppm, it is considered that oxides will remain in the additive manufactured object, and the conductivity will decrease and characteristics as an object will be inferior, but when the pure copper or copper alloy according to this embodiment is used, the oxygen concentration in the object can be lowered to be 200 wtppm or less, and high conductivity can be expected.

The production method of the pure copper or copper alloy powder according to this embodiment is now explained.

Foremost, a required amount of a pure copper or copper alloy powder is prepared. A pure copper or copper alloy powder having an average particle size D₅₀ (median diameter) of 10 to 150 µm is preferably used. The intended average particle size can be attained via sieving. While the pure copper or copper alloy powder can be prepared via the atomization method, the pure copper or copper alloy powder according to this embodiment may also be prepared via other methods, and is not limited to the pure copper or copper alloy powder prepared based on the foregoing method.

Next, the pure copper or copper alloy powder can be heated in the atmosphere in order to form an oxide coating on the surface thereof. The oxygen concentration and the film thickness can be adjusted based on the heating temperature and the heating time, and, for example, the heating temperature can be set to 70°C to 200°C and the heating time can be set to 2 to 48 hours. Moreover, while the oxide coating can also be intentionally formed via heating, the oxide coating that is naturally formed in the atmosphere may also be used.

Subsequently, carbon is added to the pure copper or copper alloy powder on which an oxide coating has been formed. There is no particular limitation in the method of adding carbon, and, for example, carbon black and the pure copper powder may be mixed using a ball mill or a mortar. Otherwise, a liquid organic compound may be heated in an inert atmosphere to add carbon to the pure copper powder. Otherwise, a graphite film may be formed on the pure copper powder based on CVD (chemical vapor deposition). As the carbon-based material suitable for adding carbon, used may be carbon black, coal tar, pitch, coke, organic compound or the like. Here, it is necessary to adjust the carbon concentration (content) in accordance with the oxygen concentration. It is thereby possible to obtain a pure copper or copper alloy powder having the intended oxygen concentration and carbon concentration.

The evaluation method in the present disclosure is as follows.

### (Average particle size D₅₀)

Manufacturer: MicrotracBEL
Name of device: MT3300EXII
Measuring method: Laser diffraction method (volumetric basis)
Solvent: Pure water
Refractive index: 1.33

### (Oxygen concentration in the powder)

Manufacturer: LECO
Name of device: TCH600
Method of analysis: Inert gas fusion method
Amount of measured sample: 1 g
Number of measurements: Measurement was performed twice, and the average value thereof was used as the concentration.

### (Carbon concentration in the powder)

Manufacturer: LECO
Name of device: TCH600
Method of analysis: Inert gas fusion method
Amount of measured sample: 1 g
Number of measurements: Measurement was performed twice, and the average value thereof was used as the concentration.

### (Film thickness of oxide coating)

The film thickness of the oxide coating is a value calculated from the time and sputter rate required until oxygen is no longer detected upon sputtering the powder body surface at a predetermined sputter rate and detecting the Auger electrons based on Auger Electron Spectroscopy (AES) while sputtering the powder surface at a certain sputter rate. Two points are randomly selected as the locations to be detected from a single particle, and the values of the Examples represent the average value thereof.

Manufacturer: JEOL Ltd.
Name of device: AES (JAMP-7800F)
Filament current: 2.22 A
Probe voltage: 10 kV
Probe current: 1.0 × 10⁻⁸A
Probe diameter: Approximately 500 nm
Sputtering rate: 7.2 nm/min (SiO₂ equivalent)

### (XPS)

The existence of copper oxide can be confirmed with XPS. The LMM spectrum of copper can be confirmed with XPS, and it can be determined that copper oxide exists when there is a peak at 569 to 570 eV.

Manufacturer: ULVAC, Inc.

Name of device: 5600MC

### (Binding of carbon)

The existence of a graphite structure can be confirmed with Raman spectroscopy. It is possible to determine that a graphite structure exists when a maximum scattering intensity value exists in a Raman shift of 1300 to 1700 cm⁻¹ based on Raman spectrometry.
Manufacturer: Ranishow
Name of device: invia

### (Laser absorptance)

Since additive manufacturing based on a general laser system uses a fiber laser having a wavelength of roughly 1060 nm, the reflectance of the wavelength of 1060 nm is measured and the laser absorptance is thereby calculated.
Manufacturer: SHIMADZU CORPORATION
Name of device: Spectrophotometer (MPC-3100, powder holder was used)
Measuring wavelength: 300 mm to 1500 mm
Slit width: 20 nm
Reference: BaSO₄
Measured physical property value: Reflectance
Absorptance (%) = 1 - (reflectance (%))

### (Oxygen concentration and relative density of object)

A pure copper or copper alloy powder is heated up to the melting point and melted, thereafter cooled to prepare a pseudo object, and an oxygen concentration in the object is measured. As the measuring method of the oxygen concentration, the same method as the measuring method of the oxygen concentration of the foregoing powder may be used. Moreover, the Archimedes density of the pseudo object is measured, and the relative density is calculated by dividing the measured Archimedes density by the theoretical density of the pure copper or copper alloy.

### [Examples]

### (Example 1)

As the metal powder, a pure copper powder prepared based on the atomization method and having an average particle size (D₅₀) of 35.0 µm was prepared, the pure copper powder was heated for 24 hours at 150°C in the atmosphere, and an oxide coating was formed on the surface thereof. Next, the pure copper powder with an oxide coating was placed in a mortar, and carbon black was added and mixed therein to attain an oxygen concentration/carbon concentration of roughly 0.40. The oxygen concentration, the carbon concentration and the laser absorptance of the thus prepared pure copper powder were measured. Next, the prepared pure copper powder was heated to the melting point and melted, and thereafter cooled to prepare a pseudo object. The oxygen concentration, the carbon concentration, and the relative density of the obtained pseudo object were measured. The foregoing results are shown in Table 1. As shown in Table 1, it was confirmed that the pure copper powder of Example 1 has high laser absorptance. Moreover, it was confirmed that the pseudo object prepared using the pure copper powder of Example 1 has low oxygen concentration and high relative density.

**[Table 1]**

| | Carbon that was mixed | Particle size (µ m) | Oxygen concentration (wtppm) | Carbon concentration (wtppm) | Oxygen concentration/ carbon concentration | Laser absorptance (%) | Relative density of pseudo object (%) | Oxygen concentration of pseudo object (Wtppm) | Carbon concentration of pseudo object (wtppm) |
|---|---|---|---|---|---|---|---|---|---|
| Example 1 | Carbon black | 35.0 | 3200 | 8000 | 0.40 | 72 | 99.7 | 65 | 74 |
| Example 2 | Carbon black | 35.0 | 3200 | 4000 | 0.80 | 74 | 99.4 | 87 | 21 |
| Example 3 | Coal tar | 35.0 | 120 | 1600 | 0.08 | 55 | - | - | - |
| Comparative Example 1 | None | 35.0 | 3200 | 10 | 320 | 62 | 99.7 | 400 | 29 |

### (Example 2)

As the metal powder, a pure copper powder prepared based on the atomization method and having an average particle size (D₅₀) of 35.0 µm was prepared, the pure copper powder was heated for 24 hours at 150°C in the atmosphere, and an oxide coating was formed on the surface thereof. Next, the pure copper powder with an oxide coating was placed in a mortar, and carbon black was added and mixed therein to attain an oxygen concentration/carbon concentration of roughly 0.80. The oxygen concentration, the carbon concentration and the laser absorptance of the thus prepared pure copper powder were measured. Next, the prepared pure copper powder was heated to the melting point and melted, and thereafter cooled to prepare a pseudo object. The oxygen concentration, the carbon concentration, and the relative density of the obtained pseudo object were measured. The foregoing results are shown in Table 1. As shown in Table 1, it was confirmed that the pure copper powder of Example 2 has high laser absorptance. Moreover, it was confirmed that the pseudo object prepared using the pure copper powder of Example 2 has low oxygen concentration and high relative density.

### (Example 3)

As the metal powder, a pure copper powder prepared based on the atomization method and having an average particle size (D₅₀) of 35.0 µm was prepared. Next, the pure copper powder was immersed in a solution diluted with toluene containing coal tar in an amount of 5 wt%, and, after immersion, the pure copper powder extracted from the solution was heated in an inert atmosphere. The oxygen concentration, the carbon concentration, and the laser absorptance of the thus obtained pure copper powder were measured. The results are shown in Table 1. As shown in Table 1, it was confirmed that the pure copper powder of Example 3 has high laser absorptance (laser absorptance of pure copper alone is 10 to 20%). Note that, while a pseudo object was not prepared in Example 3, as with Examples 1 and 2, it can be presumed that the formation of oxide is low since the laser absorptance of the pure copper powder is high and the oxygen concentration of the pure copper powder is low, and it can be presumed that the same results as Examples 1 and 2 will be obtained concerning the pseudo object.

### (Comparative Example 1)

As the metal powder, a pure copper powder prepared based on the atomization method and having an average particle size (D₅₀) of 35.0 µm was prepared, the pure copper powder was heated for 24 hours at 150°C in the atmosphere, and an oxide coating was formed on the surface thereof. Note that, in Comparative Example 1, carbon such as carbon black was not mixed. The oxygen concentration, the carbon concentration and the laser absorptance of the thus prepared pure copper powder were measured. Moreover, the prepared pure copper powder was heated to the melting point and melted, thereafter cooled to prepare a pseudo object, and the oxygen concentration, the carbon concentration, and the relative density of the obtained pseudo object were measured. The foregoing results are shown in Table 1. As shown in Table 1, it was confirmed that the pseudo object prepared using the pure copper powder of Comparative Example 1, in which carbon was intentionally omitted, has high oxygen concentration and high relative density.

### [Industrial Applicability]

According to the present invention, the laser absorptance can be improved and the oxygen concentration in the object can be decreased in the additive manufacturing using a laser beam system. Consequently, the suppression of deterioration in characteristics such as the mechanical strength and conductivity of the additive manufactured object can be expected. Reduction of the load of laser equipment can also be expected. The pure copper or copper alloy powder according to this embodiment is particularly useful as the pure copper or copper alloy powder for additive manufacturing.

## Claims

1. A pure copper or copper alloy powder with an oxide coating, wherein the oxide coating contains carbon, and a ratio of an oxygen concentration to a carbon concentration (oxygen concentration/carbon concentration) is 5 or less.

2. The pure copper or copper alloy powder according to claim 1, wherein the oxygen concentration is 5000 wtppm or less.

3. The pure copper and copper alloy powder according to claim 1 or claim 2, wherein the carbon concentration is 100 wtppm or more.

4. The pure copper or copper alloy powder according to any one of claims 1 to 3, wherein the carbon has a graphite structure.

5. The pure copper or copper alloy powder according to any one of claims 1 to 4, wherein, when measured based on Raman spectroscopy, a maximum scattering intensity value in a Raman shift of 1000 to 2000 cm⁻¹ exists within a range of a Raman shift of 1300 to 1700 cm⁻¹.

6. The pure copper or copper alloy powder according to any one of claims 1 to 5, wherein, when a Cu LMM spectrum is analyzed with XPS, a maximum peak intensity exists at a binding energy of 569 to 571 eV.

7. The pure copper or copper alloy powder according to any one of claims 1 to 6, wherein a film thickness of the oxide coating is 5 nm or more and 500 nm or less.

8. The pure copper or copper alloy powder according to any one of claims 1 to 7, wherein an average particle size D₅₀ (median diameter) is 10 µm or more and 150 µm or less.

9. The pure copper or copper alloy powder according to any one of claims 1 to 8, wherein the pure copper or copper alloy powder is a copper alloy containing pure copper or copper in an amount of 80 wt% or higher.

10. The pure copper or copper alloy powder according to any one of claims 1 to 9, wherein the pure copper or copper alloy powder is used for additive manufacturing using a laser beam.
